# EUROPEAN PATENT APPLICATION

(11) **EP 4 757 548 A1**
(43) Date of publication of application: **10.06.2026**
(21) Application number: 24849317.3
(22) Date of filing: 28.02.2024
(51) Int. Cl.: H10H 20/84, H10H 20/831, H10H 29/01, H10H 20/00

(54) **LIGHT-EMITTING ELEMENT AND DISPLAY DEVICE**

(30) Priority: 02.08.2023 KR 20230101289
(71) Applicant: Samsung Display Co., Ltd., Yongin-si, Gyeonggi-do 17113 (KR)
(72) Inventor: KIM, In Hyuk, Yongin-si, Gyeonggi-do 17113 (KR); KIM, Dae Hyun, Yongin-si, Gyeonggi-do 17113 (KR); SEO, Dong Kyun, Yongin-si, Gyeonggi-do 17113 (KR); SIM, Young Chul, Yongin-si, Gyeonggi-do 17113 (KR); YOO, Chul Jong, Yongin-si, Gyeonggi-do 17113 (KR); JIN, Tae Ha, Yongin-si, Gyeonggi-do 17113 (KR); CHOI, Hyeong Su, Yongin-si, Gyeonggi-do 17113 (KR)
(74) Representative: Marks & Clerk LLP
(86) International application number: PCT/KR2024/002591
(87) International publication number: WO 2025/028744

(57) **Abstract**

A light emitting element that includes a first semiconductor layer; a second semiconductor layer disposed on the first semiconductor layer; an active layer disposed between the first semiconductor layer and the second semiconductor layer; a first insulating film at least partially surrounding the first semiconductor layer, the second semiconductor layer, and the active layer; a second insulating film surrounding the first insulating film; and a third insulating film surrounding the second insulating film, wherein a bond dissociation energy of the second insulating film may be less than each of a bond dissociation energy of the first insulating film and a bond dissociation energy of the third insulating film.

## Description

### Technical Field

The disclosure relates to a light emitting element and a display device.

### Background Art

Recently, as interest in information display devices is increasing, research and development in display devices are continuously being conducted.

### Detailed Description of Invention

### Technical Problem

Embodiments of the disclosure is to improve reliability of a light emitting element.

Embodiments of the disclosure may not be limited to the embodiment mentioned above, and other technical objects that may not be mentioned may be clearly understood by a person of an ordinary skill in the art using the following description.

### Technical Solution

An embodiment provides a light emitting element that includes a first semiconductor layer; a second semiconductor layer disposed on the first semiconductor layer; an active layer disposed between the first semiconductor layer and the second semiconductor layer; a first insulating film at least partially surrounding the first semiconductor layer, the second semiconductor layer, and the active layer; a second insulating film surrounding the first insulating film; and a third insulating film surrounding the second insulating film, wherein a bond dissociation energy of the second insulating film may be less than each of a bond dissociation energy of the first insulating film and a bond dissociation energy of the third insulating film.

The bond dissociation energy of the first insulating film may be in a range of about 7.0 eV to about 9.0 eV.

The bond dissociation energy of the second insulating film may be in a range of about 6.0 eV to about 8.5 eV.

The bond dissociation energy of the third insulating film may be in a range of about 7.0 eV to about 9.0 eV.

The first insulating film and the third insulating film may include a same material.

A thickness of the first insulating film may be greater than a thickness of the second insulating film.

The thickness of the first insulating film may be in a range of about 1 nm to about 5 nm, and the thickness of the second insulating film may be in a range of about 1 nm to about 3 nm.

A thickness of the third insulating film may be greater than a thickness of the second insulating film.

The thickness of the third insulating film may be in a range of about 1 nm to about 5 nm, and the thickness of the second insulating film may be in a range of about 1 nm to about 3 nm.

The light emitting element may further include a fourth insulating film surrounding the third insulating film.

An embodiment provides a display device that includes a plurality of electrodes spaced apart from each other; and a plurality of light emitting elements disposed between ones of the plurality of electrodes, wherein each of the plurality of light emitting elements includes a first semiconductor layer; a second semiconductor layer disposed on the first semiconductor layer; an active layer disposed between the first semiconductor layer and the second semiconductor layer; a first insulating film at least partially surrounding the first semiconductor layer, the second semiconductor layer, and the active layer; a second insulating film surrounding the first insulating film; and a third insulating film surrounding the second insulating film, wherein a bond dissociation energy of the second insulating film may be less than each of a bond dissociation energy of the first insulating film and a bond dissociation energy of the third insulating film.

The bond dissociation energy of the first insulating film may be in a range of about 7.0 eV to about 9.0 eV.

The bond dissociation energy of the second insulating film may be in a range of about 6.0 eV to about 8.5 eV.

The bond dissociation energy of the third insulating film may be in a range of about 7.0 eV to about 9.0 eV.

The first insulating film and the third insulating film may include a same material.

A thickness of the first insulating film may be greater than a thickness of the second insulating film.

The thickness of the first insulating film may be in a range of about 1 nm to about 5 nm, and the thickness of the second insulating film may be in a range of about 1 nm to about 3 nm.

A thickness of the third insulating film may be greater than a thickness of the second insulating film.

The thickness of the third insulating film may be in a range of about 1 nm to about 5 nm, and the thickness of the second insulating film may be in a range of about 1 nm to about 3 nm.

The display device may further include a plurality of connection electrodes disposed on the plurality of light emitting elements and being electrically connected to the plurality of light emitting elements.

Particularities of other embodiments may be included in the detailed description and drawings.

### Advantageous Effects

According to the embodiments of the disclosure, it is possible to improve reliability of a light emitting element by minimizing damage to an active layer by forming a bond dissociation energy of a second insulating film to be smaller than a bond dissociation energy of a first insulating film and smaller than a bond dissociation energy of a third insulating film.

Effects of embodiments of the disclosure may not be limited by what is illustrated in the above, and more various effects may be included in the specification.

### Description of Drawings

The above and other aspects, features, and advantages of certain embodiments of the disclosure will be more apparent from the following description taken in conjunction with the accompanying drawings, in which:
FIG. 1 illustrates a perspective view of a light emitting element according to an embodiment;
FIG. 2 and FIG. 3 illustrate schematic cross-sectional views of a light emitting element according to an embodiment;
FIG. 4 illustrates a top plan view of a display device according to an embodiment;
FIG. 5 illustrates a schematic diagram of an equivalent circuit of a pixel according to an embodiment;
FIG. 6 and FIG. 7 illustrate top plan views of a pixel according to an embodiment;
FIG. 8 illustrates a schematic cross-sectional view taken along line A-A' of FIG. 6;
FIG. 9 illustrates a schematic cross-sectional view taken along line B- B' of FIG. 6;
FIG. 10 illustrates a schematic cross-sectional view taken along line C-C' of FIG. 7;
FIG. 11 illustrates a schematic cross-sectional view taken along line D-D' of FIG. 7;
FIG. 12 illustrates a schematic cross-sectional view of first to third pixels according to an embodiment; and
FIG. 13 illustrates a schematic cross-sectional view of a pixel according to an embodiment.

### Modes of the Invention

In the following description, for the purposes of explanation, numerous specific details are set forth in order to provide a thorough understanding of various embodiments or implementations of the invention. As used herein "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing features of the invention. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals and/or reference characters denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the X-axis, the Y-axis, and the Z-axis are not limited to three axes of a rectangular coordinate system, such as the x, y, and z axes, and may be interpreted in a broader sense. For example, the X-axis, the Y-axis, and the Z-axis may be perpendicular to one another, or may represent different directions that are not perpendicular to one another.

For the purposes of this disclosure, "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Terms that are spatially relative, such as "below" and "above," may be used for purposes of description and, in doing so, describe the relationship between one element or feature and other element(s) or feature(s) as illustrated in the drawings. Spatially relative terms are intended to encompass different orientations of an apparatus in use, operation, and/or manufacture in addition to the orientation depicted in the drawings. For example, if the device illustrated in the drawings is turned over, elements described as being "below" other elements or features would be oriented in the "above" direction of the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, unless specifically stated otherwise, the singular form also includes the plural form.. Moreover, the terms "comprises," and/or "comprising," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described with reference to drawings illustrating ideal embodiments. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

Unless otherwise defined or implied herein, all terms (including technical and scientific terms) used herein have the same meaning as commonly understood by those skilled in the art to which this disclosure pertains. It will be further understood that terms, such as those defined in commonly used dictionaries, should be interpreted as having a meaning that is consistent with their meaning in the context of the relevant art and the disclosure, and should not be interpreted in an ideal or excessively formal sense unless clearly so defined herein.

Hereinafter, embodiments of the disclosure will be described in detail with reference to the accompanying drawings.

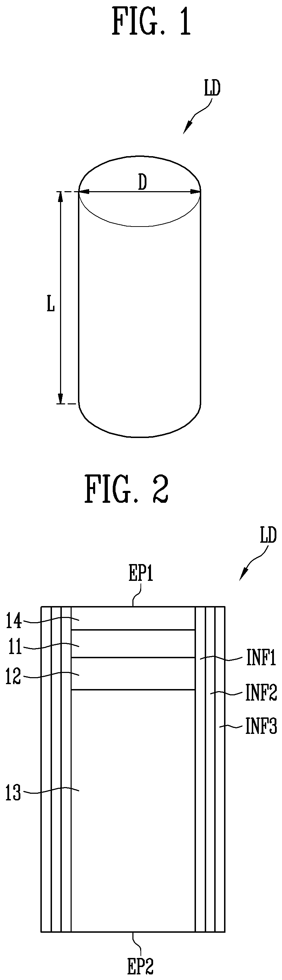

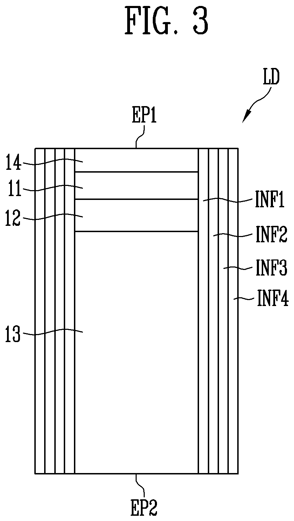

FIG. 1 illustrates a perspective view of a light emitting element according to an embodiment. FIG. 2 and FIG. 3 illustrate schematic cross-sectional views of a light emitting element according to an embodiment. FIG. 1 to FIG. 3 illustrate a cylindrical shape light emitting element LD, but a type and/or shape of the light emitting element LD may not be limited thereto.

Referring to FIG. 1 and FIG. 3, a light emitting element LD may include a first semiconductor layer 11, an active layer 12, a second semiconductor layer 13, and/or an electrode layer 14.

The light emitting element LD may be formed to have a cylindrical shape extending along a direction. The light emitting element LD may have a first end portion EP1 and a second end portion EP2. One of the first and second semiconductor layers 11 and 13 may be disposed on the first end portion EP1 of the light emitting element LD. The remaining one of the first and second semiconductor layers 11 and 13 may be disposed on the second end portion EP2 of the light emitting element LD. For example, the first semiconductor layer 11 may be disposed on the first end portion EP1 of the light emitting element LD, and the second semiconductor layer 13 may be disposed on the second end EP2 of the light emitting element LD.

In some embodiments, the light emitting element LD may be a light emitting element manufactured in a cylindrical shape through an etching method or the like. In the specification, the "cylindrical shape" includes a rod-like shape or bar-like shape with an aspect ratio greater than 1, such as a circular cylinder or a polygonal cylinder, but a shape of a cross-section of the light emitting element LD may not be limited.

The light emitting element LD may have a size as small as a nanometer scale to a micrometer scale. The light emitting element LD may each have a diameter D (or width) and/or a length L ranging from a nanometer scale to a micrometer scale. For example, a diameter of the light emitting element LD may be about 4 µm or less. However, the size of the light emitting element LD may not be limited thereto, and the size of the light emitting element LD may be variously changed according to design conditions of various devices using a light emitting device using the light emitting element LD as a light source, for example, a display device.

The first semiconductor layer 11 may be a first conductive semiconductor layer. For example, the first semiconductor layer 11 may include a p-type semiconductor layer. For example, the first semiconductor layer 11 may include at least one semiconductor material of InAlGaN, GaN, AlGaN, InGaN, and AIN, and may include a p-type semiconductor layer doped with a first conductive dopant such as Mg. However, the material included in the first semiconductor layer 11 may not be limited thereto, and the first semiconductor layer 11 may be made of various materials.

The active layer 12 may be disposed between the first semiconductor layer 11 and the second semiconductor layer 13. The active layer 12 may include one of a single well structure, a multi-well structure, a single quantum well structure, a multi-quantum well (MQW) structure, a quantum dot structure, and a quantum line structure, but may not be necessarily limited thereto. The active layer 12 may include GaN, InGaN, InAlGaN, AlGaN, AIN, or a combination thereof, and the active layer 12 may include various other materials. In the case that a voltage of a threshold voltage or more is applied to respective ends of the light emitting element LD, the light emitting element LD emits light while electron-hole pairs may be combined in the active layer 12. By controlling the light emitting of the light emitting element LD by using this principle, the light emitting element LD may be used as a light source for various light emitting devices in addition to pixels of a display device.

The second semiconductor layer 13 may be disposed to on the active layer 12, and may include a semiconductor layer of a type different from that of the first semiconductor layer 11. The second semiconductor layer 13 may include an n-type semiconductor layer. For example, the second semiconductor layer 13 may include a semiconductor material of one of InAlGaN, GaN, AlGaN, InGaN, AIN, or a combination thereof, and may include an n-type semiconductor layer doped with a second conductive dopant such as Si, Ge, Sn, the like, or a combination thereof. However, the material included in the second semiconductor layer 13 may not be limited thereto, and the second semiconductor layer 13 may be made of various materials.

The electrode layer 14 may be disposed on the first end portion EP1 and/or the second end portion EP2 of the light emitting element LD. FIG. 2 and FIG. 3 illustrate the case in which the electrode layer 14 may be formed on the first semiconductor layer 11, but the disclosure may not be necessarily limited thereto. For example, a separate electrode layer may be further disposed on the second semiconductor layer 13.

The electrode layer 14 may include a transparent metal or transparent metal oxide. As an example, the electrode layer 14 may include at least one of an indium tin oxide (ITO), an indium zinc oxide (IZO), and a zinc tin oxide (ZTO), but may not be limited thereto. As such, in the case that the electrode layer 14 is made of the transparent metal or transparent metal oxide, light generated in the active layer 12 of the light emitting element LD may transmit through the electrode layer 14 to be emitted to the outside of the light emitting element LD.

A first insulating film INF1 may be provided on the light emitting element LD. The first insulating film INF1 may at least partially surround the first semiconductor layer 11, the active layer 12, the second semiconductor layer 13, and/or the electrode layer 14. The first insulating film INF1 may be disposed (e.g., directly disposed) on surfaces of the first semiconductor layer 11, the active layer 12, the second semiconductor layer 13, and/or the electrode layer 14. The first insulating film INF1 may expose the first and second end portions EP1 and EP2 of the light emitting element LD having different polarities.

The first insulating film INF1 may minimize surface defects of the light emitting elements LD to improve lifespan and luminous efficiency of the light emitting elements LD. Generally, oxygen may be separated from the first insulating film INF1 due to heat generated during driving, and the oxygen separated from the first insulating film INF1 may penetrate into the active layer 12 to damage the active layer 12, thereby causing a decrease in reliability. Therefore, in order to suppress oxygen from being separated from the first insulating film INF1, the first insulating layer INF1 may be made of a material with high bond dissociation energy. As an example, the bond dissociation energy of the first insulating film INF1 may be in a range of about 7.0 eV to about 9.0 eV, but may not be necessarily limited thereto.

A second insulating film INF2 may be provided on the first insulating film INF1. The second insulating film INF2 may surround the first insulating film INF1. The second insulating film INF2 may be placed (e.g., directly placed) on a surface of the first insulating film INF1. The second insulating film INF2 may expose the first and second end portions EP1 and EP2 of the light emitting element LD having different polarities.

The second insulating film INF2 may improve the reliability of the light emitting element LD by compensating for defects of the first insulating film INF1. For example, even if an oxygen vacancy may be formed due to deterioration of the first insulating film INF1, oxygen may be supplied from the second insulating film INF2 to compensate for the defect in the first insulating film INF1. For this purpose, the bond dissociation energy of the second insulating film INF2 may be smaller than the bond dissociation energy of the bond dissociation energy of the first insulating film INF1. As an example, the bond dissociation energy of the first insulating film INF1 may be in a range of about 6.0 eV to about 8.5 eV, but may not be necessarily limited thereto.

A third insulating film INF3 may be provided on the second insulating film INF2. The third insulating film INF3 may surround the second insulating film INF2. The third insulating film INF3 may be disposed (e.g., directly disposed) on a surface of the second insulating film INF2. The third insulating film INF3 may expose the first and second end portions EP1 and EP2 of the light emitting element LD having different polarities.

The third insulating film INF3 may improve the reliability of the light emitting element LD by blocking oxygen from being introduced from the outside. As an example, the third insulating film INF3 may be an insulating film formed on the outside of the light emitting element LD, and may be exposed to the outside. The third insulating film INF3 may prevent oxygen from diffusing into the active layer 12 by blocking a path through which oxygen flows into the first insulating film INF1 and the second insulating film INF2 formed therein. To this end, the third insulating film INF3 may be made of a material with high bond dissociation energy. The bond dissociation energy of the third insulating film INF3 may be greater than the bond dissociation energy of the second insulating film INF2. The bond dissociation energy of the third insulating film INF3 may be the same as the bond dissociation energy of the first insulating film INF1. As an example, the bond dissociation energy of the third insulating film INF1 may be in a range of about 7.0 eV to about 9.0 eV, but may not be necessarily limited thereto. In the embodiment, the third insulating film INF3 and the first insulating film INF1 may include a same material, but may not be necessarily limited thereto.

In the embodiment, the thickness of the first insulating film INF1 may be greater than the thickness of the second insulating film INF2. For example, the thickness of the first insulating film INF1 may be in a range of about 1 nm to about 5 nm, and the thickness of the second insulating film INF2 may be in a range of about 1 nm to about 3 nm, but may not be necessarily limited thereto. The thickness of the third insulating film INF3 may be greater than the thickness of the second insulating film INF2. The thickness of the third insulating film INF3 may be the same as the thickness of the first insulating film INF1. For example, the thickness of the third insulating film INF3 may be in a range of about 1 nm to about 5 nm, and the thickness of the second insulating film INF2 may be in a range of about 1 nm to about 3 nm, but may not be necessarily limited thereto.

In some embodiments, as shown in FIG. 3, a fourth insulating film INF4 may be further provided on the third insulating film INF3. The fourth insulating film INF4 may surround the third insulating film INF3. The fourth insulating film INF4 may be disposed (e.g., directly disposed) on a surface of the third insulating film INF3. The fourth insulating film INF4 may expose the first and second end portions EP1 and EP2 of the light emitting element LD having different polarities. In some embodiments, the fourth insulating film INF4 may be omitted.

The first insulating film INF1, the second insulating film INF2, the third insulating film INF3, and/or the fourth insulating film INF4 may be made of an inorganic insulating material. For example, the first insulating film INF1, the second insulating film INF2, the third insulating film INF3, and/or the fourth insulating film INF4 may include various inorganic materials including a silicon oxide (SiOₓ), a zirconium oxide (ZrOₓ), a hafnium oxide (HfOₓ), a tantalum oxide (TaOₓ), a lanthanum oxide (LaOₓ), or a combination thereof. However, the materials included in the first insulating film INF1, the second insulating film INF2, the third insulating film INF3, and/or the fourth insulating film INF4 may not be necessarily limited thereto, and may be varied in a range that satisfies the bond dissociation energy range described above.

A light emitting device including the light emitting element LD described above may be used in various types of devices that require a light source in addition to a display device. For example, the light emitting elements LD may be disposed in each pixel of a display panel, and the light emitting elements LD may be used as a light source of each pixel. However, an application field of the light emitting element LD may not be limited to the above-described example. For example, the light emitting element LD may be used in other types of devices that require a light source, such as a lighting device.

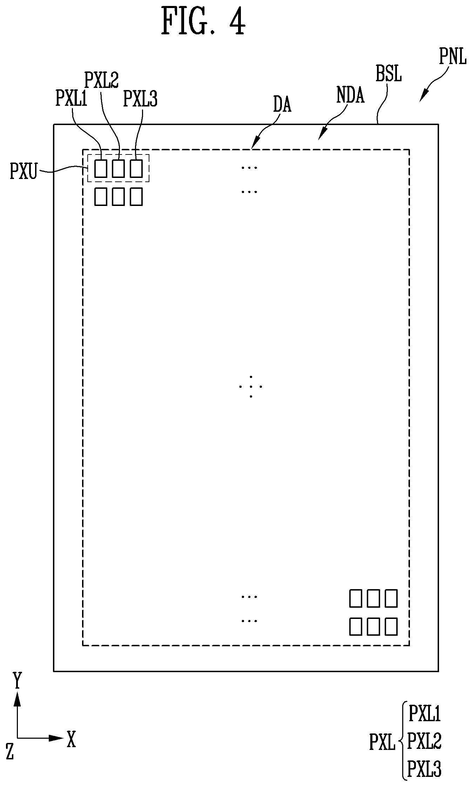

FIG. 4 illustrates a top plan view of a display device according to an embodiment.

FIG. 4 illustrates a display device, in particular, a display panel PNL provided in the display device as an example of an electronic device that may use the light emitting element LD described in the embodiments of FIG. 1 to FIG. 3 as a light source.

For better understanding and ease of description, FIG. 4 briefly illustrates a structure of the display panel PNL based on a display area DA. However, in some embodiments, at least one driving circuit portion (for example, at least one of a scan driver and a data driver), wires, and/or pads, which may not be shown, may be further disposed in the display panel PNL.

Referring to FIG. 4, the display panel PNL and a base layer BSL for forming the display panel include the display area DA for displaying an image and a non-display area NDA excluding the display area DA. The display area DA may configure a screen on which an image may be displayed, and the non-display area NDA may be the remaining area except for the display area DA.

A pixel part PXU may be disposed in the display area DA. The pixel part PXU may include a first pixel PXL1, a second pixel PXL2, and/or a third pixel PXL3. Hereinafter, in the case that arbitrarily referring to at least one of the first pixel PXL1, the second pixel PXL2, and third pixel PXL3, or in the case that comprehensively referring to two or more types of pixels of the first pixel PXL1, the second pixel PXL2 and the third pixel PXL3, they will be referred to as a "pixel PXL" or "pixels PXL".

The pixels PXL may be regularly arranged according to a stripe or PENTILE^{™} arrangement structure. However, the arrangement structure of the pixels PXL may not be limited thereto, and the pixels PXL may be arranged in the display area DA in various structures and/or methods.

In some embodiments, two or more types of pixels PXL emitting light of different colors may be disposed in the display area DA. For example, in the display area DA, a first pixels PXL1 emitting light of the first color, a second pixels PXL2 emitting light of the second color, and a third pixels PXL3 emitting light of the third color may be arranged. At least one of the first to third pixels PXL1, PXL2, and PXL3 disposed to be adjacent to each other may form one pixel part PXU that may emit light of various colors. For example, each of the first to third pixels PXL1, PXL2, and PXL3 may be a pixel that emits light of a color (e.g., a predetermined or selectable color). In some embodiments, the first pixel PXL1 may be a red pixel that emits red light, the second pixel PXL2 may be a green pixel that emits green light, and the third pixel PXL3 may be a blue pixel that emits blue light, but the disclosure may not be limited thereto.

In the embodiment, the first pixel PXL1, the second pixel PXL2, and third pixel PXL3 may be provided with light emitting elements of the same color, and include color conversion layers and/or color filter layers of different colors disposed on respective light emitting elements, so that they may emit light of the first color, the second color, and the third color, respectively. In an embodiment, the first pixel PXL1, the second pixel PXL2, and third pixel PXL3 may be each provided with a first color light emitting element, a second color light emitting element, and a third color light emitting element as a light source, respectively, so that they respectively emit light of the first color, second color, and third color. However, the color, type, and/or number of pixels PXL configuring each pixel part PXU may not be particularly limited. For example, the color of light emitted by each pixel PXL may be variously changed.

The pixel PXL may include at least one light source driven by a control signal (for example, a scan signal and a data signal) and/or a power source (for example, a first power source and a second power source). In the embodiment, the light source may include at least one light emitting element LD according to one of the embodiments of FIG. 1 and FIG. 3, for example, ultra-small cylindrical shape light emitting elements LD having a size as small as nanometer scale to micrometer scale. However, the disclosure may not be limited thereto, and various types of light emitting elements LD may be used as a light source of the pixel PXL.

In the embodiment, each pixel PXL may be configured as active pixel. However, the type, structure, and/or driving method of pixels PXL that may be applied to the display device may not be particularly limited. For example, each pixel PXL may be configured as a pixel of a passive or active light emitting display device of various structures and/or driving methods.

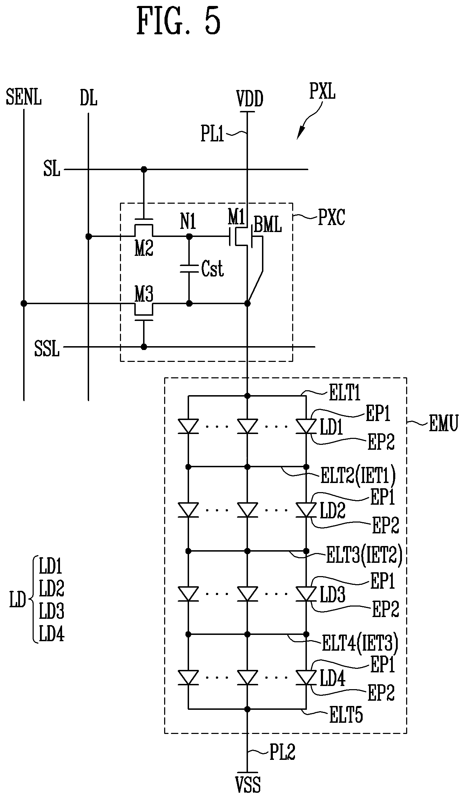

FIG. 5 illustrates a schematic diagram of an equivalent circuit of a pixel according to an embodiment.

The pixel PXL shown in FIG. 5 may be one of the first pixel PXL1, the second pixel PXL2, and the third pixel PXL3 provided in the display panel PNL of FIG. 4. The first pixel PXL1, the second pixel PXL2, and the third pixel PXL3 may have substantially the same or similar structure.

Referring to FIG. 5, the pixel PXL may further include a light emitting portion EMU for generating light at luminance corresponding to a data signal, and a pixel circuit PXC for driving a light emitting portion EMU.

The pixel circuit PXC may be electrically connected between a first power source VDD and the light emitting portion EMU. The pixel circuit PXC may be electrically connected to a scan line SL and a data line DL of the pixel PXL to control an operation of the light emitting portion EMU in response to a scan signal and a data signal supplied from the scan line SL and the data line DL. The pixel circuit PXC may be further selectively electrically connected to a sensing signal line SSL and a sensing line SENL.

The pixel circuit PXC may include at least one transistor and a capacitor. For example, the pixel circuit PXC may include a first transistor M1, a second transistor M2, a third transistor M3, and a storage capacitor Cst.

The first transistor M1 may be electrically connected between the first power source VDD and a first connection electrode ELT1. A gate electrode of the first transistor M1 may be electrically connected to a first node N1. The first transistor M1 may control a driving current supplied to the light emitting portion EMU in response to a voltage of the first node N1. For example, the first transistor M1 may be a driving transistor that controls a driving current of the pixel PXL.

In the embodiment, the first transistor M1 may optionally include a lower conductive layer BML (also referred to as a "lower electrode", "back gate electrode", or "lower light blocking layer"). The gate electrode of the first transistor M1 and the lower conductive layer BML may overlap each other with an insulating film disposed therebetween. In the embodiment, the lower conductive layer BML may be electrically connected to one electrode of the first transistor M1, for example a source or drain electrode first transistor M1.

In the case that the first transistor M1 includes the lower conductive layer BML, by applying a back-biasing voltage to the lower conductive layer BML of the first transistor M1 in the case that the pixel PXL is driven, a back-biasing technique (or a sync technique) of moving a threshold voltage of the first transistor M1 in a negative or positive direction may be applied. For example, by connecting the lower conductive layer BML to the source electrode of the first transistor M1 to apply a source-sync technique, the threshold voltage of the first transistor M1 may be moved in the negative or positive direction. In the case that the lower conductive layer BML is disposed under a semiconductor pattern forming a channel of the first transistor M1, the lower conductive layer BML may serve as a light blocking pattern to stabilize an operating characteristic of the first transistor M1. However, the function and/or utilization method of the lower conductive layer BML may not be limited thereto.

The second transistor M2 may be electrically connected between the data line DL and the first node N1. A gate electrode of the second transistor M2 may be electrically connected to the scan line SL. In the case that a scan signal of a gate-on voltage (for example, a high level voltage) is supplied from the scan line SL, the second transistor M2 may be turned on to connect the data line DL and the first node N1.

For each frame period, a data signal of the corresponding frame may be supplied to the data line DL, and the data signal be transmitted to the first node N1 through the turned-on second transistor M2 during a period in which the scan signal of the gate-on voltage may be supplied. For example, the second transistor M2 may be a switching transistor for transmitting each data signal to the inside of the pixel PXL.

An electrode of the storage capacitor Cst may be electrically connected to the first node N1, and another electrode of the storage capacitor Cst may be electrically connected to a second electrode of the first transistor M1. The storage capacitor Cst may be charged with a voltage corresponding to the data signal supplied to the first node N1 during each frame period.

The third transistor M3 may be electrically connected between the first connection electrode ELT1 (or the second electrode of the first transistor M1) and the sensing line SENL. A gate electrode of the third transistor M3 may be electrically connected to a sensing signal line SSL. The third transistor M3 may transmit a voltage applied to the first connection electrode ELT1 to the sensing line SENL according to a sensing signal supplied to the sensing signal line SSL. The voltage transmitted through the sensing line SENL may be provided to an external circuit (for example, a timing controller), and the external circuit may detect characteristic information (for example, a threshold voltage of the first transistor M1) of each pixel PXL based on the supplied voltage. The detected characteristic information may be used to convert image data so that a characteristic deviation between the pixels PXL may be compensated.

In FIG. 5, all the transistors included in the pixel circuit PXC may be illustrated as N-type transistors, but the disclosure may not be limited thereto. For example, at least one of the first, second, and third transistors M1, M2, and M3 may be changed to a p-type transistor.

The structure and driving method of the pixel PXL may be variously changed. For example, the pixel circuit PXC may be configured as a pixel circuit having various structures and/or driving methods in addition to that of the embodiment shown in FIG. 5.

For example, the pixel circuit PXC may not include the third transistor M3. The pixel circuit PXC may further include other circuit elements such as a compensation transistor for compensating for a threshold voltage of the first transistor M1, an initialization transistor for initializing the voltage of the first node N1 and/or of the first connection electrode ELT1, a light emission control transistor for controlling a period in which a driving current may be supplied to the light emitting part EMU, and/or a boosting capacitor for boosting the voltage of the first node N1.

The light emitting portion EMU may include at least one light emitting element LD electrically connected between the first power source VDD and a second power source VSS, for example, plurality of light emitting elements LD.

For example, the light emitting portion EMU may include the first connection electrode ELT1 electrically connected to the first power source VDD through the pixel circuit PXC and a first power line PL1, a fifth connection electrode ELT5 electrically connected to the second power source VSS through a second power line PL2, and multiple light emitting elements LD electrically connected between the first and fifth connection electrodes ELT1 and ELT5.

The first and second power sources VDD and VSS may have different potentials so that the light emitting elements LD may emit light. For example, the first power source VDD may be set as a high potential power source, and the second power source VSS may be set as a low potential power source.

In the embodiment, the light emitting portion EMU may include at least one serial stage. Each serial stage may include a pair of electrodes (for example, two electrodes) and at least one light emitting element LD electrically connected in a forward direction between the pair of electrodes. Here, the number of serial stages forming the light emitting portion EMU and the number of light emitting elements LD forming each serial stage may not be particularly limited. For example, the number of the light emitting elements LD configuring respective serial stages may be the same or different from each other, but the number of the light emitting elements LD may not be particularly limited.

For example, the light emitting portion EMU may include a first serial stage including at least one first light emitting element LD1, a second serial stage including at least one second light emitting element LD2, a third serial stage including at least one third light emitting element LD3, and a fourth serial stage including at least one fourth light emitting element LD4.

The first serial stage may include the first connection electrode ELT1, the second connection electrode ELT2, and at least one first light emitting element LD1 electrically connected between the first and second connection electrodes ELT1 and ELT2. Each first light emitting element LD1 may be electrically connected in a forward direction between the first and second connection electrodes ELT1 and ELT2. For example, the first end portion EP1 of the first light emitting element LD1 may be electrically connected to the first connection electrode ELT1, and the second end portion EP2 of the first light emitting element LD1 may be electrically connected to the second connection electrode ELT2.

The second serial stage may include the second connection electrode ELT2, a third connection electrode ELT3, and at least one second light emitting element LD2 electrically connected between the second and third connection electrodes ELT2 and ELT3. Each second light emitting element LD2 may be electrically connected in a forward direction between the second and third connection electrodes ELT2 and ELT3. For example, the first end portion EP1 of the second light emitting element LD2 may be electrically connected to the second connection electrode ELT2, and the second end portion EP2 of the second light emitting element LD2 may be electrically connected to third connection electrode ELT3.

The third serial stage may include the third connection electrode ELT3, the fourth connection electrode ELT4, and at least one third light emitting element LD3 electrically connected between the third and fourth connection electrodes ELT3 and ELT4. Each third light emitting element LD3 may be electrically connected in a forward direction between the third and fourth connection electrodes ELT3 and ELT4. For example, the first end portion EP1 of the third light emitting element LD3 may be electrically connected to the third connection electrode ELT3, and the second end portion EP2 of the third light emitting element LD3 may be electrically connected to fourth connection electrode ELT4.

The fourth serial stage may include the fourth connection electrode ELT4, the fifth connection electrode ELT5, and at least one fourth light emitting element LD4 electrically connected between the fourth and fifth connection electrodes ELT4 and ELT5. Each fourth light emitting element LD4 may be electrically connected in a forward direction between the fourth and fifth connection electrodes ELT4 and ELT5. For example, the first end portion EP1 of the fourth light emitting element LD4 may be electrically connected to the fourth connection electrode ELT4, and the second end portion EP2 of the fourth light emitting element LD4 may be electrically connected to the fifth connection electrode ELT5.

A first electrode of the light emitting portion EMU, for example, the first connection electrode ELT1 may be an anode electrode of the light emitting portion EMU. A last electrode of the light emitting portion EMU, for example, the fifth connection electrode ELT5 may be a cathode electrode of the light emitting portion EMU.

The remaining electrodes of the light emitting portion EMU, for example, the second connection electrode ELT2, the third connection electrode ELT3, and/or the fourth connection electrode ELT4, may configure respective intermediate electrodes. For example, the second connection electrode ELT2 may configure a first intermediate electrode IET1, the third connection electrode ELT3 may configure a second intermediate electrode IET2, and the fourth connection electrode ELT4 may configure a third intermediate electrode IET3.

In the case that the light emitting elements LD are electrically connected in a serial/parallel structure, power efficiency may be improved compared with a case that the same number of light emitting elements LD are electrically connected only in parallel. In the pixel PXL in which the light emitting elements LD may be electrically connected in a serial/parallel structure, even if a short circuit defect occurs at some of the serial stages, since a luminance may be displayed through the light emitting elements LD in the remaining serial stages, the possibility of dark spot defects of the pixel PXL may be reduced. However, the disclosure may not be limited thereto, and the light emitting portion EMU may be configured by connecting the light emitting elements LD only in series or only in parallel.

Each of the light emitting elements LD may include the first end portion EP1 (for example, a p-type end portion) electrically connected to the first power source VDD via at least one electrode (for example, the first connection electrode ELT1), the pixel circuit PXC and/or the first power line PL1, and the second end portion EP2 (for example, an p-type end portion) electrically connected to the second power source VSS via at least one other electrode (for example, the fifth connection electrode ELT5) and second power line PL2. For example, the light emitting elements LD may be electrically connected in a forward direction between the first power source VDD and the second power source VSS. The light emitting elements LD electrically connected to the forward direction may configure the effective light sources of the light emitting portion EMU.

In the case that a driving current may be supplied through the corresponding pixel circuit PXC, the light emitting elements LD may emit light with luminance corresponding to the driving current. For example, during each frame period, the pixel circuit PXC may supply a driving current corresponding to a grayscale value to be displayed in the corresponding frame to the light emitting portion EMU. Accordingly, while the light emitting elements LD emit light with luminance corresponding to the driving current, the light emitting portion EMU may display the luminance corresponding to the driving current.

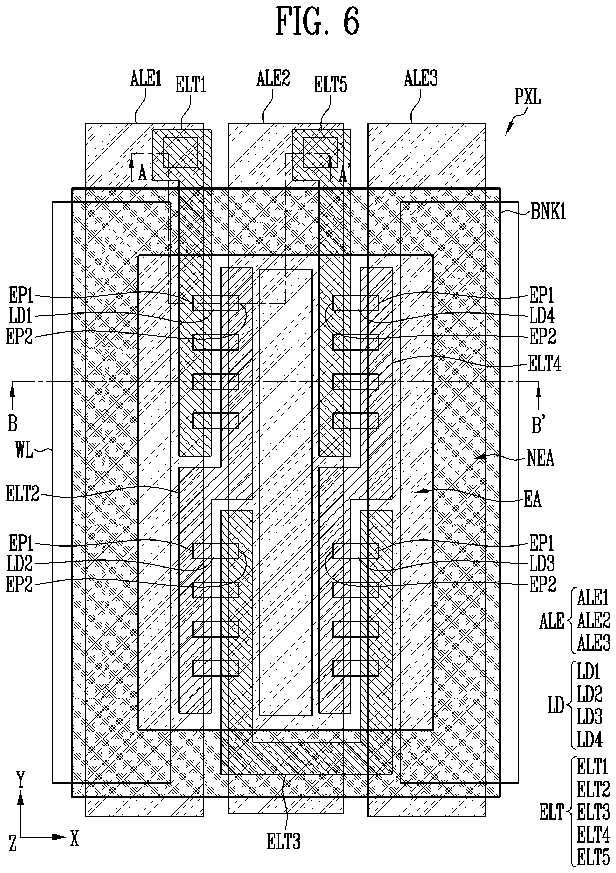

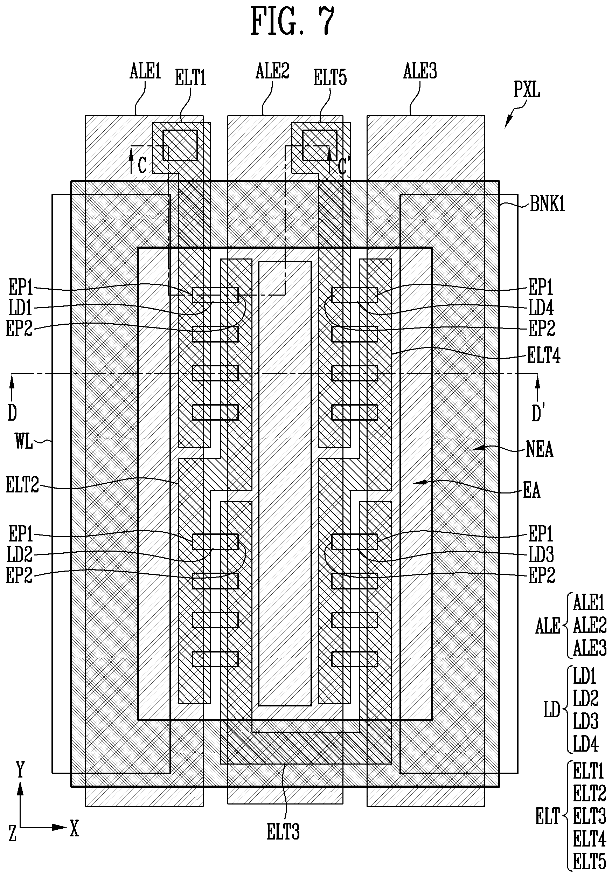

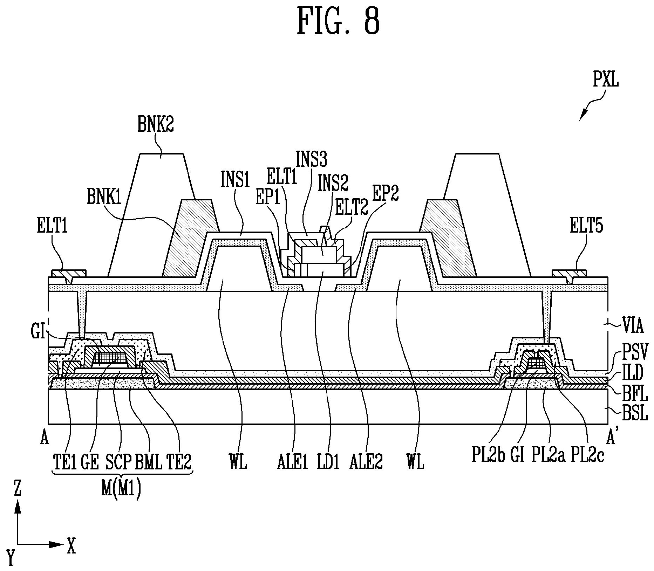

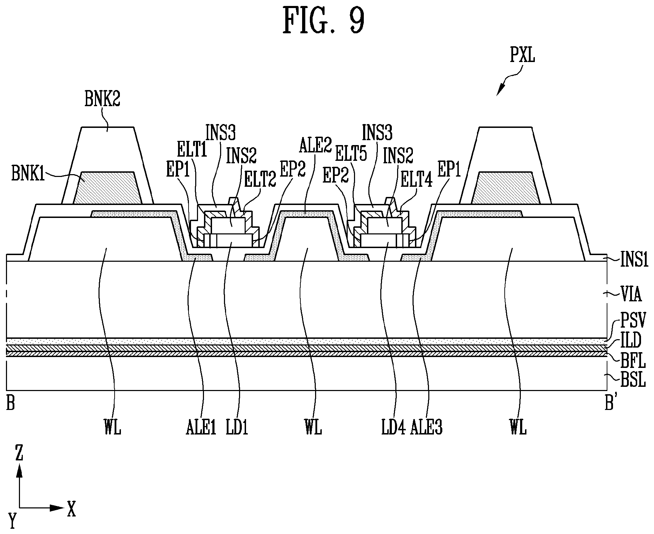

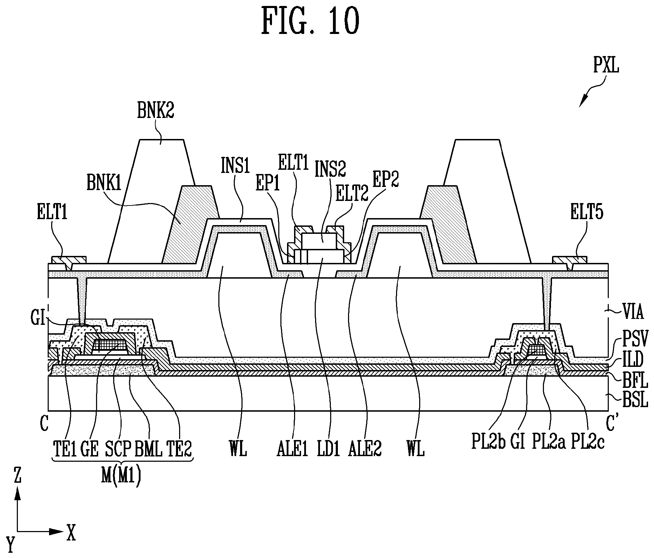

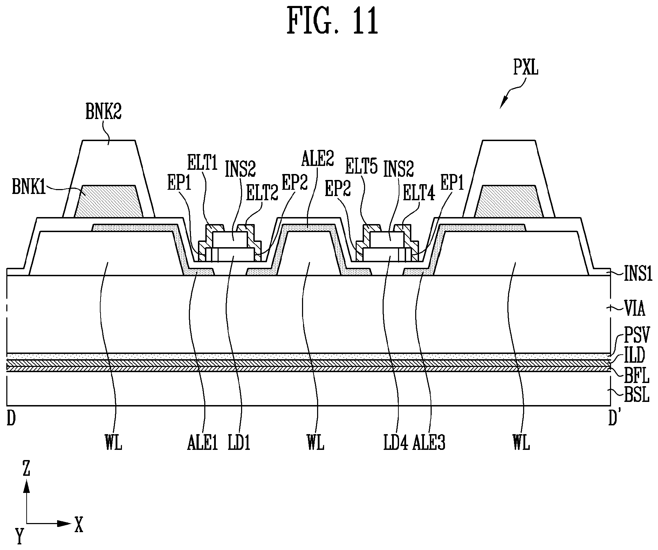

FIG. 6 and FIG. 7 illustrate top plan views of a pixel according to an embodiment. FIG. 8 illustrates a schematic cross-sectional view taken along line A-A' of FIG. 6. FIG. 9 illustrates a schematic cross-sectional view taken along line B- B' of FIG. 6. FIG. 10 illustrates a schematic cross-sectional view taken along line C-C' of FIG. 7. FIG. 11 illustrates a schematic cross-sectional view taken along line D-D' of FIG. 7.

As an example, FIG. 6 and FIG. 7 may be one of the first to third pixels PXL1, PXL2, and PXL3 configuring the pixel part PXU of FIG. 4, and the first to third pixels PXL1, PXL2, and PXL3 may be substantially the same or similar to each other. FIG. 6 and FIG. 7 illustrate the embodiment in which each pixel PXL includes the light emitting elements LD disposed in the four serial stages as shown in FIG. 5, but the number of serial stages of each pixel PXL may be variously changed according to embodiments.

Hereinafter, in the case that arbitrarily referring to one or more light emitting element among first to fourth light emitting elements LD1, LD2, LD3, and LD4, or comprehensively referring to two or more light emitting elements, it or they will be referred to as a "light emitting element LD" or "light emitting elements LD" will be referred. In the case that arbitrarily referring to at least one of electrodes including first to third electrodes ALE1, ALE2, and ALE3, it or they will be referred to as an "electrode ALE" or "electrodes ALE", and in the case that arbitrarily referring to at least one of electrodes including first to fifth connection electrodes ELT1, ELT2, ELT3, ELT4, and ELT5, it or they will be referred to as an "connection electrode ELT" or "connection electrodes ELT".

Referring to FIG. 6 to FIG. 7, each pixel PXL may include a light emitting area EA and a non-light emitting area NEA. The light emitting area EA may be an area that may emit light by including the light emitting elements LD. The non-light emitting area NEA may be disposed to surround the light emitting area EA. The non-light emitting area NEA may be an area in which a first bank BNK1 surrounding the light emitting area EA may be provided. The first bank BNK1 may be provided to the non-light emitting area NEA to be disposed to at least partially surround the light emitting area EA.

The first bank BNK1 may include an opening overlapping the light emitting area EA. The opening of the first bank BNK1 may provide a space in which the light emitting elements LD may be provided in a step of supplying the light emitting elements LD to each of the pixels PXL. For example, a desired type and/or amount of light emitting element ink may be supplied to a space partitioned by the opening of the first bank BNK1.

The first bank BNK1 may include an organic material such as an acrylate resin, an epoxy resin, a phenolic resin, a polyamide resin, a polyimide resin, a polyester resin, a polyphenylene sulfide resin, benzocyclobutene (BCB), or a combination thereof. However, it may not be necessarily limited thereto, and the first bank BNK1 may be configured as a single layer or multilayer, and may include a silicon oxide (SiOₓ), a silicon nitride (SiNₓ), a silicon oxynitride (SiOₓN_{y}), an aluminium nitride (AlNₓ), an aluminium oxide (AlOₓ), a zirconium oxide (ZrOₓ), a hafnium oxide (HfOₓ), a titanium oxide (TiOₓ), various types of inorganic materials, or a combination thereof.

In some embodiments, the first bank BNK1 may include at least one light blocking and/or reflective material. Accordingly, light leakage between adjacent pixels PXL may be prevented. For example, the first bank BNK1 may include at least one black pigment.

Each pixel PXL may include partition walls WL, electrodes ALE, light emitting elements LD, and/or connection electrodes ELT.

The partition walls WL may overlap the light emitting area EA, and may be spaced apart from each other. The partition walls WL may be at least partially disposed in the non-light emitting area NEA. The partition walls WL may extend along the second direction (Y-axis direction), and may be spaced apart from each other along the first direction (X-axis direction).

The partition walls WL may at least partially overlap at least one electrode ALE in the light emitting area EA. For example, the partition walls WL may be provided below the electrodes ALE, respectively. As the partition walls WL are provided under an area of each of the electrodes ALE, an area of each of the electrodes ALE in areas in which the partition walls WL are formed may protrude in an upper direction of the pixel PXL, for example, a third direction (Z-axis direction). When the partition walls WL and/or the electrodes ALE include a reflective material, a reflective wall structure may be formed around the light emitting elements LD. Accordingly, as light emitted from the light emitting elements LD may be directed in an upper direction (for example, a front direction of the display panel PNL including a viewing angle range) of the pixel PXL, light emission efficiency of the pixel PXL may be improved.

The electrodes ALE may be provided in at least the light emitting area EA. The electrodes ALE may extend along a second direction (Y-axis direction), and may be spaced apart from each other along a first direction (X-axis direction).

The first to third electrodes ALE1, ALE2, and ALE3 may extend along the second direction (Y-axis direction), respectively, and may be spaced apart from each other along the first direction (X-axis direction) to be sequentially disposed. Some of the electrodes ALE may be electrically connected to the pixel circuit (PXC of FIG. 5) and/or a power line (e.g., a predetermined or selectable power line) through a contact hole. For example, the first electrode ALE1 may be electrically connected to the pixel circuit PXC and/or the first power line PL1 through the contact hole, and the second electrode ALE2 may be electrically connected to the second power line PL2 through the contact hole.

In some embodiments, some of the electrodes ALE may be electrically connected to some of the connection electrodes ELT through a contact hole. For example, the first electrode ALE1 may be electrically connected to the first connection electrode ELT1 through the contact hole, and the second electrode ALE2 may be electrically connected to the fifth connection electrode ELT5 through the contact hole.

A pair of electrodes ALE adjacent to each other may receive different signals in an alignment step of the light emitting elements LD. For example, in the case that the first to third electrodes ALE1, ALE2, and ALE3 are sequentially arranged along the first direction (X-axis direction), the first electrode ALE1 and the second electrode ALE2 may be supplied with different alignment signals, and the second electrode ALE2 and the third electrode ALE3 may be supplied with different alignment signals.

Each of the light emitting elements LD may be aligned between the pair of electrodes ALE in the light emitting area EA. Each of the light emitting elements LD may be electrically connected between a pair of connection electrodes ELT.

The first light emitting element LD1 may be aligned between the first and second electrodes ALE1 and ALE2. The first light emitting element LD1 may be electrically connected between the first and second connection electrodes ELT1 and ELT2. As an example, the first light emitting element LD1 may be aligned in an first area (for example, an upper end area) of the first and second electrodes ALE1 and ALE2, and the first end portion EP1 of the first light emitting element LD1 may electrically connected to the first connection electrode ELT1, and the second end portion EP2 of the first light emitting element LD1 may be electrically connected to the second connection electrode ELT2.

The second light emitting element LD2 may be aligned between the first and second electrodes ALE1 and ALE2. The second light emitting element LD2 may be electrically connected between the second and third connection electrodes ELT2 and ELT3. As an example, the second light emitting element LD2 may be aligned in a second area (for example, a lower end area) of the first and second electrodes ALE1 and ALE2, and the first end portion EP1 of the second light emitting element LD2 may electrically connected to the second connection electrode ELT2, and the second end portion EP2 of the second light emitting element LD2 may be electrically connected to the third connection electrode ELT3.

The third light emitting element LD3 may be aligned between the second and third electrodes ALE2 and ALE3. The third light emitting element LD3 may be electrically connected between the third and fourth connection electrodes ELT3 and ELT4. As an example, the third light emitting element LD3 may be aligned in a second area (for example, a lower end area) of the second and third electrodes ALE2 and ALE3, and the first end portion EP1 of the third light emitting element LD3 may electrically connected to the third connection electrode ELT3, and the second end portion EP2 of the third light emitting element LD3 may be electrically connected to the fourth connection electrode ELT4.

The fourth light emitting element LD4 may be aligned between the second and third electrodes ALE2 and ALE3. The fourth light emitting element LD4 may be electrically connected between the fourth and fifth connection electrodes ELT4 and ELT5. As an example, the fourth light emitting element LD4 may be aligned in the first area (for example, the upper end area) of the second and third electrodes ALE2 and ALE3, and the first end portion EP1 of the fourth light emitting element LD4 may electrically connected to the fourth connection electrode ELT4, and the second end portion EP2 of the fourth light emitting element LD4 may be electrically connected to the fifth connection electrode ELT5.

For example, the first light emitting element LD1 may be disposed in an upper left area of the light emitting area EA, and the second light emitting element LD2 may be disposed in a lower left area of the light emitting area EA. The third light emitting element LD3 may be disposed in a lower right area of the light emitting area EA, and the fourth light emitting element LD4 may be disposed in an upper right area of the light emitting area EA. However, the arrangement and/or connection structure of the light emitting elements LD may be variously changed depending on the structure of the light emitting portion EMU and/or the number of serial stages.

Each of the connection electrodes ELT may be at least provided in the light emitting area EA, and may be disposed to overlap at least one electrode ALE and/or at least one light emitting element LD. For example, each of the connection electrodes ELT may be formed on the electrodes ALE and/or the light emitting elements LD to overlap the electrodes ALE and/or the light emitting elements LD to be electrically connected to the light emitting elements LD.

The first connection electrode ELT1 may be disposed on the first area (for example, the upper area) of the first electrode ALE1 and on the first end portions EP1 of the first light emitting elements LD1 to be electrically connected to the first end portions EP1 of the first light emitting elements LD1.

The second connection electrode ELT2 may be disposed on the first area (for example, the upper end area) of the second electrode ALE2 and on the second end portions EP2 of the first light emitting elements LD1 to be electrically connected to the second end portions EP2 of the first light emitting elements LD1. The second connection electrode ELT2 may be disposed on the second area (for example, the lower end area) of the first electrode ALE1 and on the first end portions EP1 of the second light emitting elements LD2 to be electrically connected to the first end portions EP1 of the second light emitting elements LD2. For example, the second connection electrode ELT2 may electrically connect the second end portions EP2 of the first light emitting elements LD1 and the first end portions EP1 of the second light emitting elements LD2 in the light emitting area EA. For this, the second connection electrode ELT2 may have a curved shape. For example, the second connection electrode ELT2 may have a curved or bent structure at a boundary between an area in which at least one first light emitting element LD1 may be arranged and an area in which at least one second light emitting element LD2 may be arranged.

The third connection electrode ELT3 may be disposed on the second area (for example, the lower end area) of the second electrode ALE2 and on the second end portions EP2 of the second light emitting elements LD2 to be electrically connected to the second end portions EP2 of the second light emitting elements LD2. The third connection electrode ELT3 may be disposed on the second area (for example, the lower end area) of the third electrode ALE3 and on the first end portions EP1 of the third light emitting elements LD3 to be electrically connected to the first end portions EP1 of the third light emitting elements LD3. For example, the third connection electrode ELT3 may electrically connect the second end portions EP2 of the second light emitting elements LD2 and the first end portions EP1 of the third light emitting elements LD3 in the light emitting area EA. For this, the third connection electrode ELT3 may have a curved shape. For example, the third connection electrode ELT3 may have a curved or bent structure at a boundary between an area in which at least one second light emitting element LD2 may be arranged and an area in which at least one third light emitting element LD3 may be arranged.

The fourth connection electrode ELT4 may be disposed on the second area (for example, the lower area) of the second electrode ALE2 and on the second end portions EP2 of the third light emitting elements LD3 to be electrically connected to the second end portions EP2 of the third light emitting elements LD3. The fourth connection electrode ELT4 may be disposed on the first area (for example, the upper end area) of the third electrode ALE3 and the first end portions EP1 of the fourth light emitting elements LD4 to be electrically connected to the first end portions EP1 of the fourth light emitting elements LD4. For example, the fourth connection electrode ELT4 may electrically connect the second end portions EP2 of the third light emitting elements LD3 and the first end portions EP1 of the fourth light emitting elements LD4 in the light emitting area EA. For this, the fourth connection electrode ELT4 may have a curved shape. For example, the fourth connection electrode ELT4 may have a curved or bent structure at a boundary between an area in which at least one third light emitting element LD3 may be arranged and an area in which at least one fourth light emitting element LD4 may be arranged.

The fifth connection electrode ELT5 may be disposed on the first area (for example, the upper area) of the second electrode ALE2 and on the second end portions EP2 of the fourth light emitting elements LD4 to be electrically connected to the second end portions EP2 of the fourth light emitting elements LD4.

The first connection electrode ELT1, the third connection electrode ELT3, and/or the fifth connection electrode ELT5 may be formed of a same conductive layer as each other. The second connection electrode ELT2 and the fourth connection electrode ELT4 may be formed of a same conductive layer as each other. For example, as shown in FIG. 6, the connection electrodes ELT may include multiple conductive layers. For example, the first connection electrode ELT1, the third connection electrode ELT3, and/or the fifth connection electrode ELT5 may be formed of the first conductive layer, and the second connection electrode ELT2 and the fourth connection electrode ELT4 may be formed of a second conductive layer different from the first conductive layer. As shown in FIG. 7, the first to fifth connection electrodes ELT1, ELT2, ELT3, ELT4, and ELT5 may be formed of the same conductive layer as each other.

According to the above-described manner, the light emitting elements LD arranged between the electrodes ALE may be electrically connected in a desired shape by using the connection electrodes ELT. For example, the first light emitting elements LD1, the second light emitting elements LD2, the third light emitting elements LD3, and the fourth light emitting elements LD4 may be sequentially electrically connected in series by using the connection electrodes ELT.

Hereinafter, a cross-sectional structure of the pixel PXL will be described in detail with reference to FIG. 8 to FIG. 11. FIG. 8 to FIG. 11 illustrate the first transistor M1 among various circuit elements configuring the pixel circuit (PXC in FIG. 5), and in the case that it is not necessary to separately denote the first to third transistors M1, M2, and M3, they will be comprehensively referred to a "transistor M". Structures of the transistors M and/or a position of each layer of the transistors M may not be limited to the embodiments shown in FIG. 8 and FIG. 10, and may be variously changed according to embodiments.

The pixels PXL according to the embodiment may include circuit elements including the transistors M disposed on the base layer BSL and various wires electrically connected thereto. The electrodes ALE, the light emitting elements LD, the connection electrodes ELT, the first bank BNK1, and/or the second bank BNK2 configuring the light emitting portion EMU may be disposed on the circuit elements.

The base layer BSL configures a base member, and may be a rigid or flexible substrate or film. For example, the base layer BSL may be a hard substrate made of glass or tempered glass, a flexible substrate (or a thin film) made of a plastic or metallic material, or at least one layered insulating film. The material and/or physical properties of the base layer BSL may not be particularly limited. In the embodiment, the base layer BSL may be substantially transparent. Here, the "substantially transparent" may mean that light may be transmitted at a transmittance or more. In an embodiment, the base layer BSL may be translucent or opaque. In some embodiments, the base layer BSL may include a reflective material.

The lower conductive layer BML and a first power conductive layer PL2a may be disposed on the base layer BSL. The lower conductive layer BML and the first power conductive layer PL2a may be disposed on a same layer. For example, the lower conductive layer BML and the first power conductive layer PL2a may be simultaneously formed in the same process, but the disclosure may not be limited thereto. The first power conductive layer PL2a may configure the second power line PL2 described with reference to FIG. 5 and the like.

Each of the lower conductive layer BML and the first power conductive layer PL2a may be provided as a single layer or multilayer made of molybdenum (Mo), copper (Cu), aluminium (Al), chromium (Cr), gold (Au), titanium (Ti), nickel (Ni), neodymium (Nd), indium (In), tin (Sn), oxide thereof, an alloy thereof, or a combination thereof.

A buffer layer BFL may be disposed on the lower conductive layer BML and the first power conductive layer PL2a. The buffer layer BFL may prevent impurities from diffusing into the circuit element. The buffer layer BFL may be configured as a single layer, but may also be configured as a multilayer of at least two layers. In the case that the buffer layer BFL is configured as the multilayer, respective layers may be made of a same material or different materials.

A semiconductor pattern SCP may be disposed on the buffer layer BFL. For example, the semiconductor pattern SCP may include a first area contacting a first transistor electrode TE1, a second area contacting a second transistor electrode TE2, and a channel area disposed between the first and second areas. In some embodiments, one of the first and second areas may be a source area, and another of the first and second areas may be a drain area.

In some embodiments, the semiconductor pattern SCP may be made of polysilicon, amorphous silicon, an oxide semiconductor, the like, or a combination thereof. The channel area of the semiconductor pattern SCP may be an intrinsic semiconductor as a semiconductor pattern that may not be doped with impurities, and each of the first and second areas of the semiconductor pattern SCP may be a semiconductor doped with impurities.

A gate insulating layer GI may be disposed on the buffer layer BFL and the semiconductor pattern SCP. For example, the gate insulating layer GI may be disposed between the semiconductor pattern SCP and the gate electrode GE. The gate insulating layer GI may be disposed between the buffer layer BFL and a second power conductive layer PL2b. The gate insulating layer GI may be configured as a single layer or multilayer, and may include a silicon oxide (SiOₓ), a silicon nitride (SiNₓ), a silicon oxynitride (SiOₓN_{y}), an aluminium nitride (AlNₓ), an aluminium oxide (AlOₓ), a zirconium oxide (ZrOₓ), a hafnium oxide (HfOₓ), a titanium oxide (TiOₓ), various types of inorganic materials, or a combination thereof.

A gate electrode GE of the transistor M and the second power conductive layer PL2b may be disposed on the gate insulating layer GI. The gate electrode GE and the second power conductive layer PL2b may be disposed on a same layer. For example, the gate electrode GE and the second power conductive layer PL2b may be simultaneously formed in a same process, but the disclosure may not be limited thereto. The gate electrode GE may be disposed to overlap the semiconductor pattern SCP in a third direction (a Z-axis direction) on the gate insulating layer GI. The second power conductive layer PL2b may be disposed to overlap the gate insulating layer GI on the first power conductive layer PL2a in the third direction (Z-axis direction). The second power conductive layer PL2b together with the first power conductive layer PL2a may configure the second power line PL2 described with reference to FIG. 5 and the like.

Each of the gate electrode GE and the second power conductive layer PL2b may be formed as a single layer or multilayer made of molybdenum (Mo), copper (Cu), aluminium (Al), chromium (Cr), gold (Au), titanium (Ti), nickel (Ni), neodymium (Nd), indium (In), tin (Sn), an oxide thereof, an alloy thereof, or a combination thereof. For example, each of the gate electrode GE and the second power conductive layer PL2b may be formed as a multilayer in which titanium (Ti), copper (Cu), and/or an indium tin oxide (ITO) may be sequentially or repeatedly stacked on each other.

An interlayer insulating layer ILD may be disposed on the gate electrode GE and the second power conductive layer PL2b. For example, the interlayer insulating layer ILD may be disposed between the gate electrode GE and the first and second transistor electrodes TE1 and TE2. The interlayer insulating layer ILD may be disposed between the second power conductive layer PL2b and a third power conductive layer PL2c.

The interlayer insulating layer ILD may be configured as a single layer or multilayer, and may include a silicon oxide (SiOₓ), a silicon nitride (SiNₓ), a silicon oxynitride (SiOₓN_{y}), an aluminium nitride (AlNₓ), an aluminium oxide (AlOₓ), a zirconium oxide (ZrOₓ), a hafnium oxide (HfOₓ), a titanium oxide (TiOₓ), various types of inorganic materials, or a combination thereof.

The first and second transistor electrodes TE1 and TE2 of the transistor M and a third power conductive layer PL2c may be disposed on the interlayer insulating layer ILD. The first and second transistor electrodes TE1 and TE2 and the third power conductive layer PL2c may be disposed on a same layer. For example, the first and second transistor electrodes TE1 and TE2 and the third power conductive layer PL2c may be simultaneously formed in a same process, but may not be limited thereto.

The first and second transistor electrodes TE1 and TE2 may be disposed to overlap the semiconductor pattern SCP in the third direction (Z-axis direction). The first and second transistor electrodes TE1 and TE2 may be electrically connected to the semiconductor pattern SCP. For example, the first transistor electrode TE1 may be electrically connected to the first area of the semiconductor pattern SCP through a contact hole penetrating the interlayer insulating layer ILD. The first transistor electrode TE1 may be electrically connected to the lower conductive layer BML through a contact hole penetrating the interlayer insulating layer ILD and the buffer layer BFL. The second transistor electrode TE2 may be electrically connected to the second area of the semiconductor pattern SCP through a contact hole penetrating the interlayer insulating layer ILD. In some embodiments, one of the first and second transistor electrodes TE1 and TE2 may be a source electrode, and another of the first and second transistor electrodes TE1 and TE2 may be a drain electrode.

The third power conductive layer PL2c may be disposed to overlap the first power conductive layer PL2a and/or the second power conductive layer PL2b in the third direction (Z-axis direction). The third power conductive layer PL2c may be electrically connected to the first power conductive layer PL2a and/or the second power conductive layer PL2b. For example, the third power conductive layer PL2c may be electrically connected to the first power conductive layer PL2a through a contact hole penetrating the interlayer insulating layer ILD and the buffer layer BFL. The third power conductive layer PL2c may be electrically connected to the second power conductive layer PL2b through a contact hole penetrating the interlayer insulating layer ILD. The third power conductive layer PL2c together with the first power conductive layer PL2a and/or the second power conductive layer PL2b may configure the second power line PL2 described with reference to FIG. 5 and the like.

The first and second transistor electrodes TE1 and TE2 and the third power conductive layer PL2c may be formed as a single layer or multilayer made of molybdenum (Mo), copper (Cu), aluminium (Al), chromium (Cr), gold (Au), titanium (Ti), nickel (Ni), neodymium (Nd), indium (In), tin (Sn), an oxide thereof, an alloy thereof, or a combination thereof.

A passivation layer PSV may be disposed on the first and second transistor electrodes TE1 and TE2 and the third power conductive layer PL2c. The passivation layer PSV may be configured as a single layer or a multilayer, and may include a silicon oxide (SiOₓ), a silicon nitride (SiNₓ), a silicon oxynitride (SiOₓN_{y}), an aluminium nitride (AlNₓ), an aluminium oxide (AlOₓ), a zirconium oxide (ZrOₓ), a hafnium oxide (HfOₓ), a titanium oxide (TiOₓ), various types of inorganic materials, or a combination thereof.

A via layer VIA may be disposed on the passivation layer PSV. The via layer VIA may be made of an organic material to flatten a lower step thereof. For example, the via layer VIA may include an organic material such as an acrylate resin, an epoxy resin, a phenolic resin, a polyamide resin, a polyimide resin, a polyester resin, a polyphenylene sulfide resin, benzocyclobutene (BCB), or a combination thereof. However, it may not be necessarily limited thereto, and the via layer VIA may include a silicon oxide (SiOₓ), a silicon nitride (SiNₓ), a silicon oxynitride (SiOₓN_{y}), an aluminium nitride (AlNₓ), an aluminium oxide (AlOₓ), a zirconium oxide (ZrOₓ), a hafnium oxide (HfOₓ), a titanium oxide (TiOₓ), various types of inorganic materials, or a combination thereof.

Partition walls WL may be disposed on the via layer VIA. The partition walls WL may serve to form a step to readily align the light emitting elements LD in the light emitting area EA.

The partition walls WL may have various shapes according to embodiments. In the embodiment, the partition walls WL may have a shape protruding in the third direction (Z-axis direction) on the base layer BSL. The partition walls WL may be formed to have an inclined surface inclined at an angle (e.g., a predetermined or selectable angle) with respect to the base layer BSL. However, the disclosure may not be necessarily limited thereto, and the partition walls WL may have a side wall having a curved surface or a step shape. For example, the partition walls WL may have a cross-section of a semicircular or semi-elliptical shape.

The partition walls WL may include at least one organic material and/or inorganic material. For example, the partition walls WL may include an organic material such as an acrylate resin, an epoxy resin, a phenolic resin, a polyamide resin, a polyimide resin, a polyester resin, a polyphenylene sulfide resin, benzocyclobutene (BCB), or a combination thereof. However, it may not be necessarily limited thereto, and the partition walls WL may include a silicon oxide (SiOₓ), a silicon nitride (SiNₓ), a silicon oxynitride (SiOₓN_{y}), an aluminium nitride (AlNₓ), an aluminium oxide (AlOₓ), a zirconium oxide (ZrOₓ), a hafnium oxide (HfOₓ), a titanium oxide (TiOₓ), various types of inorganic materials, or a combination thereof.

The electrodes ALE may be disposed on the via layer VIA and the partition walls WL. The electrodes ALE may at least partially cover side surfaces and/or upper surfaces of the partition walls WL. The electrodes ALE disposed on the partition walls WL may have shapes corresponding to the partition walls WL. For example, the electrodes ALE disposed on the partition walls WL may include inclined surfaces or curved surfaces having shapes corresponding to the shapes of the partition walls WL. The partition walls WL and the electrodes ALE may be reflective members and may reflect light emitted from the light emitting elements LD to guide emitted light in the front surface direction of the pixel PXL, for example, in the third direction (Z-axis direction), so that the light output efficiency of the display panel PNL may be improved.

The electrodes ALE may be disposed to be spaced apart from each other. The electrodes ALE may be disposed on a same layer. For example, the electrodes ALE may be simultaneously formed in a same process, but may not be limited thereto.

The electrodes ALE may receive an alignment signal in the alignment step of the light emitting elements LD. Accordingly, an electric field may be formed between the electrodes ALE so that the light emitting elements LD provided to each pixel PXL may be aligned between the electrodes ALE.

The electrodes ALE may include at least one conductive material. For example, the electrodes ALE may include at least one metal of various metal materials including silver (Ag), magnesium (Mg), aluminium (Al), platinum (Pt), palladium (Pd), gold (Au), nickel (Ni), neodymium (Nd), iridium (Ir), chromium (Cr), titanium (Ti), molybdenum (Mo), copper (Cu), an alloy including the same, or a combination thereof; a conductive oxide such as an indium tin oxide (ITO), an indium zinc oxide (IZO), an indium tin zinc oxide (ITZO), an aluminium zinc oxide (AZO), a gallium zinc oxide (GZO), a zinc tin oxide (ZTO), a gallium tin oxide (GTO), or a combination thereof; and at least one conductive material among conductive polymers such as PEDOT, but may not be necessarily limited thereto.

The first electrode ALE1 may be electrically connected to the first transistor electrode TE1 of the transistor M through a contact hole penetrating the via layer VIA and the passivation layer PSV. The second electrode ALE2 may be electrically connected to the third power conductive layer PL2c through a contact hole penetrating the via layer VIA and the passivation layer PSV.

A first insulating layer INS1 may be disposed on the electrodes ALE. The first insulating layer INS1 may be configured as a single layer or multilayer, and may include a silicon oxide (SiOₓ), a silicon nitride (SiNₓ), a silicon oxynitride (SiOₓN_{y}), an aluminium nitride (AlNₓ), an aluminium oxide (AlOₓ), a zirconium oxide (ZrOₓ), a hafnium oxide (HfOₓ), a titanium oxide (TiOₓ), various types of inorganic materials, or a combination thereof.

The first bank BNK1 may be disposed on the first insulating layer INS1. The first bank BNK1 may include an opening overlapping the light emitting area EA. The opening of the first bank BNK1 may provide a space in which the light emitting elements LD may be provided in a step of supplying the light emitting elements LD to each of the pixels PXL. For example, a desired type and/or amount of light emitting element ink may be supplied to a space partitioned by the opening of the first bank BNK1.

The first bank BNK1 may include an organic material such as an acrylate resin, an epoxy resin, a phenolic resin, a polyamide resin, a polyimide resin, a polyester resin, a polyphenylene sulfide resin, benzocyclobutene (BCB), or a combination thereof. However, it may not be necessarily limited thereto, and the first bank BNK1 may be configured as a single layer or multilayer, and may include a silicon oxide (SiOₓ), a silicon nitride (SiNₓ), a silicon oxynitride (SiOₓN_{y}), an aluminium nitride (AlNₓ), an aluminium oxide (AlOₓ), a zirconium oxide (ZrOₓ), a hafnium oxide (HfOₓ), a titanium oxide (TiOₓ), various types of inorganic materials, or a combination thereof.

The light emitting elements LD may be disposed between the electrodes ALE. The light emitting elements LD may be bias-aligned between the electrodes ALE. For example, the light emitting elements LD may be bias-aligned so that the first end portion EP1 (or the first semiconductor layer) overlaps the first electrode ALE1 and the second end portion EP2 (or the second semiconductor layer) overlaps the second electrode ALE2.

The light emitting elements LD may be provided within the opening of the first bank BNK1 to be disposed between the partition walls WL. The light emitting elements LD may be prepared in a form dispersed in light emitting element ink, and may be supplied to each pixel PXL through an inkjet printing method and the like. For example, the light emitting elements LD may be dispersed in a volatile solvent to be provided in each pixel PXL. Subsequently, in the case that an alignment signal may be supplied to the electrodes ALE, an electric field may be formed between the electrodes ALE, so that the light emitting elements LD may be aligned between the electrodes ALE. After the light emitting elements LD are aligned, the light emitting elements LD may be stably arranged between the electrodes ALE by volatilizing the solvent or eliminating the solvent in other ways.

A second insulating layer INS2 may be disposed on the light emitting elements LD. For example, the second insulating layer INS2 may be partially provided on the light emitting elements LD, and may expose the first and second end portions EP1 and EP2 of the light emitting elements LD. In the case that the second insulating layer INS2 is provided on the light emitting elements LD after the alignment of the light emitting elements LD is completed, it may be possible to prevent an orientation of the light emitting elements LD from deviating from an aligned position.

The second insulating layer INS2 may be configured as a single layer or multilayer, and may include a silicon oxide (SiOₓ), a silicon nitride (SiNₓ), a silicon oxynitride (SiOₓN_{y}), an aluminium nitride (AlNₓ), an aluminium oxide (AlOₓ), a zirconium oxide (ZrOₓ), a hafnium oxide (HfOₓ), a titanium oxide (TiOₓ), various types of inorganic materials, or a combination thereof.

The connection electrodes ELT may be disposed on the first and second end portions EP1 and EP2 of the light emitting elements LD exposed by the second insulating layer INS2. The first connection electrode ELT1 may be disposed (e.g., directly disposed) on the first end portions EP1 of the first light emitting elements LD1 to contact the first end portions EP1 (or first semiconductor layers) of the first light emitting elements LD1.

The second connection electrode ELT2 may be disposed (e.g., directly disposed) on the second end portions EP2 (or second semiconductor layers) of the first light emitting elements LD1 to contact the second end portions EP2 (or second semiconductor layers) of the first light emitting elements LD1. The second connection electrode ELT2 may be disposed (e.g., directly disposed) on the first end portions EP1 (or first semiconductor layers) of the second light emitting elements LD2 to contact the first end portions EP1 (or first semiconductor layers) of the second light emitting elements LD2. For example, the second connection electrode ELT2 may electrically connect the second end portions EP2 (or second semiconductor layers) of the first light emitting elements LD1 and the first end portions EP1 (or first semiconductor layers) of the second light emitting elements LD2.

Similarly, the third connection electrode ELT3 may be disposed (e.g., directly disposed) on the second end portions EP2 (or second semiconductor layers) of the second light emitting elements LD2 to contact the second end portions EP2 (or second semiconductor layers) of the second light emitting elements LD2. The third connection electrode ELT3 may be disposed (e.g., directly disposed) on the first end portions EP1 (or first semiconductor layers) of the third light emitting elements LD3 to contact the first end portions EP1 (or first semiconductor layers) of the third light emitting elements LD3. For example, the third connection electrode ELT3 may electrically connect the second end portions EP2 (or second semiconductor layers) of the second light emitting elements LD2 and the first end portions EP1 (or first semiconductor layers) of the third light emitting elements LD2.

Similarly, the fourth connection electrode ELT4 may be disposed (e.g., directly disposed) on the second end portions EP2 (or second semiconductor layers) of the third light emitting elements LD3 to contact the second end portions EP2 (or second semiconductor layers) of the third light emitting elements LD3. The fourth connection electrode ELT4 may be disposed (e.g., directly disposed) on the first end portions EP1 (or first semiconductor layers) of the fourth light emitting elements LD4 to contact the first end portions EP1 (or first semiconductor layers) of the fourth light emitting elements LD4. For example, the fourth connection electrode ELT4 may electrically connect the second end portions EP2 (or second semiconductor layers) of the third light emitting elements LD3 and the first end portions EP1 (or first semiconductor layers) of the fourth light emitting elements LD4.

Similarly, the fifth connection electrode ELT5 may be disposed (e.g., directly disposed) on the second end portions EP2 (or second semiconductor layers) of the fourth light emitting elements LD4 to contact the second end portions EP2 (or second semiconductor layers) of the fourth light emitting elements LD4.

The first connection electrode ELT1 may be electrically connected to the first electrode ALE1 through a contact hole penetrating the first insulating layer INS1. The fifth connection electrode ELT5 may be electrically connected to the second electrode ALE2 through a contact hole penetrating the first insulating layer INS1.

In the embodiment, the connection electrodes ELT may include multiple conductive layers. For example, as shown in FIG. 8 and FIG. 9, the first connection electrode ELT1, the third connection electrode ELT3, and fifth connection electrode ELT5 may be disposed on a same layer. The second connection electrode ELT2 and the fourth connection electrode ELT4 may be disposed on a same layer. The first connection electrode ELT1, the third connection electrode ELT3, and the fifth connection electrode ELT5 may be disposed on the second insulating layer INS2. A third insulating layer INS3 may be disposed on the first connection electrode ELT1, the third connection electrode ELT3, and the fifth connection electrode ELT5. The second connection electrode ELT2 and the fourth connection electrode ELT4 may be disposed on the third insulating layer INS3.

As described above, in the case that the third insulating layer INS3 may be disposed between the connection electrodes ELT made of different conductive layers, since the connection electrodes ELT may be stably separated by the third insulating layer INS3, it may be possible to ensure electrical stability between the first and second end portions EP1 and EP2 of the light emitting elements LD.

The third insulating layer INS3 may be configured as a single layer or multilayer, and may include a silicon oxide (SiOₓ), a silicon nitride (SiNₓ), a silicon oxynitride (SiOₓN_{y}), an aluminium nitride (AlNₓ), an aluminium oxide (AlOₓ), a zirconium oxide (ZrOₓ), a hafnium oxide (HfOₓ), a titanium oxide (TiOₓ), various types of inorganic materials, or a combination thereof.

In an embodiment, the connection electrodes ELT may be formed from a same conductive layer as each other. For example, as shown in FIG. 10 and FIG. 11, the first to fifth connection electrodes ELT1, ELT2, ELT3, ELT4, and ELT5 may be disposed on a same layer. For example, the first to fifth connection electrodes ELT1, ELT2, ELT3, ELT4, and ELT5 may be simultaneously formed in the same process. As described above, in the case that the connection electrodes ELT may be simultaneously formed, the number of masks may be reduced, and the manufacturing process may be simplified.

The connection electrodes ELT may be made of various transparent conductive materials. For example, the connection electrodes ELT may include at least one of various transparent conductive materials including an indium tin oxide (ITO), an indium zinc oxide (IZO), an indium tin zinc oxide (ITZO), an aluminium zinc oxide (AZO), a gallium zinc oxide (GZO), a zinc tin oxide (ZTO), a gallium tin oxide (GTO), or a combination thereof, and may be realized to be substantially transparent or translucent to satisfy a light transmittance (e.g., a predetermined or selectable light transmittance). Accordingly, the light emitted from the first and second end portions EP1 and EP2 of the light emitting elements LD may pass through the connection electrodes ELT to be emitted to the outside of the display panel PNL.

The second bank BNK2 may be disposed on the first bank BNK1. The second bank BNK2 may be disposed in the non-light emitting area NEA.

The second bank BNK2 may include an opening overlapping the light emitting area EA. The opening of the second bank BNK2 may provide a space in which a color conversion layer to be described later may be provided. For example, a desired type and/or amount of the color conversion layer may be supplied to a space partitioned by the opening of the second bank BNK2.

The second bank BNK2 may include an organic material such as an acrylate resin, an epoxy resin, a phenolic resin, a polyamide resin, a polyimide resin, a polyester resin, a polyphenylene sulfide resin, benzocyclobutene (BCB), or a combination thereof. However, it may not be necessarily limited thereto, and the second bank BNK2 may be configured as a single layer or multilayer, and may include a silicon oxide (SiOₓ), a silicon nitride (SiNₓ), a silicon oxynitride (SiOₓN_{y}), an aluminium nitride (AlNₓ), an aluminium oxide (AlOx), a zirconium oxide (ZrOₓ), a hafnium oxide (HfOₓ), a titanium oxide (TiOₓ), various types of inorganic materials, or a combination thereof.

In some embodiments, the second bank BNK2 may include at least one light blocking and/or reflective material. Accordingly, light leakage between adjacent pixels PXL may be prevented. For example, the second bank BNK2 may include at least one black pigment.

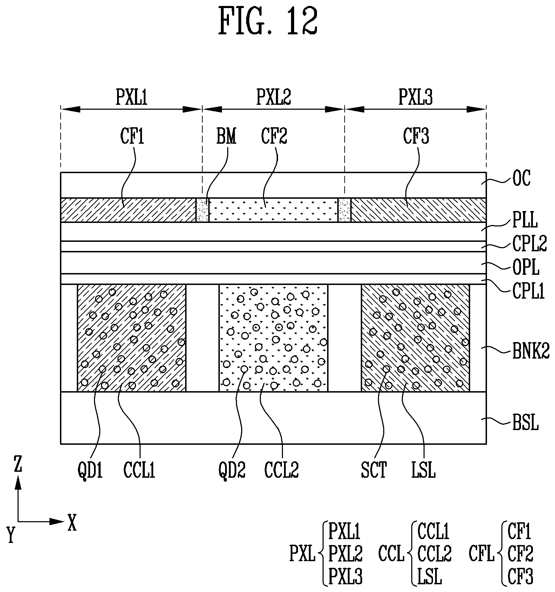

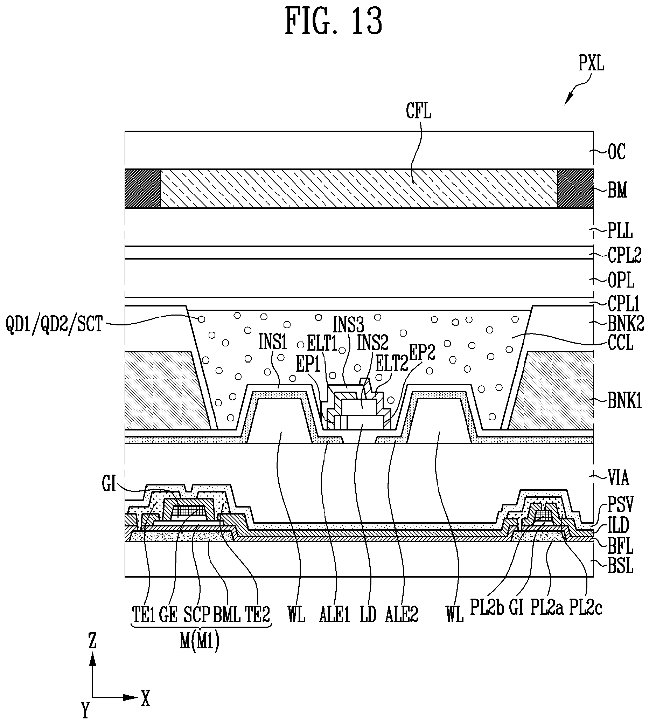

FIG. 12 illustrates a schematic cross-sectional view of first to third pixels according to an embodiment. FIG. 13 illustrates a schematic cross-sectional view of a pixel according to an embodiment.

FIG. 12 illustrates a color conversion layer CCL, an optical layer OPL, and/or a color filter layer CFL. In FIG. 12, discussion of components except for the base layer BSL and the second bank BNK2 of FIG. 8 to FIG. 11 may be omitted for better understanding and ease of description. FIG. 13 specifically illustrates a stacked structure of the pixel PXL in relation to the color conversion layer CCL, the optical layer OPL, and/or the color filter layer CFL.

Referring to FIG. 12 and FIG. 13, the second bank BNK2 may be disposed between the first to third pixels PXL1, PXL2, and PXL3 or at a boundary thereof, and may include an opening respectively overlapping the first to third pixels PXL1, PXL2, and PXL3. The opening of the second bank BNK2 may provide a space in which the color conversion layer CCL may be provided.

The color conversion layer CCL may be disposed on the light emitting elements LD in an opening of the second bank BNK2. The color conversion layer CCL may include a first color conversion layer CCL1 disposed on the first pixel PXL1, a second color conversion layer CCL2 disposed on the second pixel PXL2, and a scattering layer LSL disposed on the third pixel PXL3.

In the embodiment, the first to third pixels PXL1, PXL2, and PXL3 may include the light emitting elements LD that emit light of a same color. For example, the first to third pixels PXL1, PXL2, and PXL3 may include the light emitting elements LD that emit light of a third color (or blue color). The color conversion layer CCL including color conversion particles may be disposed on the first to third pixels PXL1, PXL2, and PXL3, respectively, thereby displaying a full-color image.

The first color conversion layer CCL1 may include first color conversion particles that convert light of the third color emitted from the light emitting element LD into light of the first color. For example, the first color conversion layer CCL1 may include multiple first quantum dots QD1 dispersed in a matrix material (e.g., predetermined or selectable matrix material) such as a base resin.

In the embodiment, in the case that the light emitting element LD is a blue light emitting element that emits blue light and the first pixel PXL1 is a red pixel, the first color conversion layer CCL1 may include a first quantum dot QD1 that converts blue light emitted from the blue light emitting element into red light. The first quantum dot QD1 may absorb blue light to shift a wavelength according to an energy transition to emit red light. In the case that the first pixel PXL1 is a pixel of a different color, the first color conversion layer CCL1 may include a first quantum dot QD1 corresponding to a color of the first pixel PXL1.

The second color conversion layer CCL2 may include second color conversion particles that convert light of the third color emitted from the light emitting element LD into light of the second color. For example, the second color converting layer CCL2 may include multiple second quantum dots QD2 dispersed in a matrix material (e.g., predetermined or selectable matrix material) such as a base resin.

In the embodiment, in the case that the light emitting element LD is a blue light emitting element that emits blue light and the second pixel PXL2 is a green pixel, the second color conversion layer CCL2 may include a second quantum dot QD2 that converts blue light emitted from the blue light emitting element into green light. The second quantum dot QD2 may absorb blue light to shift a wavelength according to an energy transition to emit green light. In the case that the second pixel PXL2 is a pixel of a different color, the second color conversion layer CCL2 may include the second quantum dot QD2 corresponding to a color of the second pixel PXL2.

In the embodiment, blue light having a relatively short wavelength among the visible ray bands may be incident on the first quantum dot QD1 and the second quantum dot QD2, respectively, thereby increasing absorption coefficient of the first quantum dot QD1 and the second quantum dot QD2. Accordingly, the efficiency of light emitted from the first pixel PXL1 and the second pixel PXL2 may be finally increased, and at the same time, excellent color reproducibility may be achieved. The light emitting portion EMU of the first to third pixels PXL1, PXL2, and PXL3 may be configured by using the light emitting elements LD of the same color (for example, the blue color light emitting element), thereby increasing the manufacturing efficiency of the display device.

The scattering layer LSL may be provided to efficiently use the third color (or blue color) light emitted from the light emitting element LD. For example, in the case that the light emitting element LD is a blue light emitting element that emits blue light and the third pixel PXL3 is a blue pixel, the scattering layer LSL may include at least one type of scatterer SCT to efficiently utilize the light emitted from the light emitting element LD. For example, the scatterer SCT of the scattering layer LSL may include at least one of a barium sulfate (BaSO₄), a calcium carbonate (CaCO₃), a titanium oxide TiO₂, a silicon oxide SiO₂, an aluminium oxide (Al₂O₃), a zirconium oxide ZrO₂, and a zinc oxide (ZnO). The scatterer SCT may not be disposed only in the third pixel PXL3, and may be selectively included in the first color conversion layer CCL1 or the second color conversion layer CCL2. In some embodiments, the scatterer SCT may be omitted so that the scattering layer LSL may be transparent.

A first capping layer CPL1 may be disposed on the color conversion layer CCL. The first capping layer CPL1 may be entirely disposed on the first to third pixels PXL1, PXL2, and PXL3. The first capping layer CPL1 may cover the color conversion layer CCL. The first capping layer CPL1 may prevent impurities such as moisture or air from penetrating from the outside to damage or contaminate the color conversion layer CCL.

The first capping layer CPL1 may be an inorganic layer, which may include a silicon nitride (SiNₓ), an aluminium nitride (AlNₓ), a titanium nitride (TiNₓ), a silicon oxide (SiOₓ), an aluminium oxide (AlOₓ), a titanium oxide (TiOₓ), a silicon oxycarbide (SiOₓC_{y}), a silicon oxynitride (SiOₓN_{y}), or a combination thereof.

The optical layer OPL may be disposed on the first capping layer CPL1. The optical layer OPL may serve to improve light extraction efficiency by recycling light provided from the color conversion layer CCL by total reflection. To this end, the optical layer OPL may have a relatively low refractive index compared to the color conversion layer CCL. For example, the refractive index of the color conversion layer CCL may be in a range of about 1.6 to about 2.0, and the refractive index of the optical layer OPL may be in a range of about 1.1 to about 1.3.

A second capping layer CPL2 may be disposed on the optical layer OPL. The second capping layer CPL2 may be entirely disposed on the first to third pixels PXL1, PXL2, and PXL3. The second capping layer CPL2 may cover the optical layer OPL. The second capping layer CPL2 may prevent impurities such as moisture or air from penetrating from the outside to damage or contaminate the optical layer OPL.

The second capping layer CPL2 may be an inorganic layer, which may include a silicon nitride (SiNₓ), an aluminium nitride (AlNₓ), a titanium nitride (TiNₓ), a silicon oxide (SiOₓ), an aluminium oxide (AlOₓ), a titanium oxide (TiOₓ), a silicon oxycarbide (SiOₓC_{y}), a silicon oxynitride (SiOₓN_{y}), or a combination thereof.

A planarization layer PLL may be disposed on the second capping layer CPL2. The planarization layer PLL may be entirely provided in the first to third pixels PXL1, PXL2, and PXL3.

The planarization layer PLL may include an organic material such as an acrylic resin, an epoxy resin, a phenolic resin, a polyamide resin, a polyimide rein, a polyester resin, a polyphenylene sulfide resin, benzocyclobutene (BCB), or a combination thereof. However, it may not be necessarily limited thereto, and the planarization layer PLL may include a silicon oxide (SiOₓ), a silicon nitride (SiNₓ), a silicon oxynitride (SiOₓN_{y}), an aluminium nitride (AlNₓ), an aluminium oxide (AlOₓ), a zirconium oxide (ZrOₓ), a hafnium oxide (HfOₓ), a titanium oxide (TiOₓ), various types of inorganic materials, or a combination thereof.

A color filter layer CFL may be disposed on the planarization layer PLL. The color filter layer CFL may include color filters CF1, CF2, and CF3 matching the color of each pixel PXL. A full-color image may be displayed by disposing the color filters CF1, CF2, and CF3 matching respective colors of the first to third pixels PXL1, PXL2, and PXL3.

The color filter layer CFL may include a first color filter CF1 that may be disposed in the first pixel PXL1 to selectively transmit light emitted by the first pixel PXL1, a second color filter CF2 that may be disposed in the second pixel PXL2 to selectively transmit light emitted by the second pixel PXL2, and a third color filter CF3 that may be disposed in the third pixel PXL3 to selectively transmit light emitted by the third pixel PXL3.

In the embodiment, the first color filter CF1, the second color filter CF2, and the third color filter CF3 may be a red color filter, a green color filter, and a blue color filter respectively, but the disclosure may not be limited necessarily thereto. Hereinafter, in the case that referring to one of the first color filter CF1, the second color filter CF2, and the third color filter CF3, or in case that comprehensively referring to two or more thereof, it will be referred to as the "color filter CF" or "color filters CF".

The first color filter CF1 may overlap the first color conversion layer CCL1 in the third direction (Z-axis direction). The first color filter CF1 may include a color filter material that selectively transmits light of a first color (or red color). For example, in the case that the first pixel PXL1 is a red pixel, the first color filter CF1 may include a red color filter material.

The second color filter CF2 may overlap the second color conversion layer CCL2 in the third direction (Z-axis direction). The second color filter CF2 may include a color filter material that selectively transmits light of a second color (or green color). For example, in the case that the second pixel PXL2 is a green pixel, the second color filter CF2 may include a green color filter material.

The third color filter CF3 may overlap the scattering layer LSL in the third direction (Z-axis direction). The third color filter CF3 may include a color filter material that selectively transmits light of a third color (or blue color). For example, in the case that the third pixel PXL3 is a blue pixel, the third color filter CF3 may include a blue color filter material.

In some embodiments, a light blocking layer BM may be further disposed between the first to third color filters CF1, CF2, and CF3, and in the case that the light blocking layer BM is formed between the first to third color filters CF1, CF2, and CF3, it may be possible to prevent a color mixing defect viewed from a front or side of a display device. A material of the light blocking layer BM may not be particularly limited, and the light blocking layer BM may be made of various light blocking materials. For example, the light blocking layer BM may be implemented by stacking the first to third color filters CF1, CF2, and CF3 on each other.

An overcoat layer OC may be disposed on the color filter layer CFL. The overcoat layer OC may be entirely provided in the first to third pixels PXL1, PXL2, and PXL3. The overcoat layer OC may cover the color filter layer CFL and a lower member thereof. The overcoat layer OC may prevent moisture or air from penetrating into the above-mentioned lower members that may be disposed below the overcoat layer OC. The overcoat layer OC may protect the above-mentioned lower members from foreign material such as dust.

The overcoat layer OC may include an organic material such as an acrylic resin, an epoxy resin, a phenolic resin, a polyamide resin, a polyimide rein, a polyester resin, a polyphenylene sulfide resin, benzocyclobutene (BCB), or a combination thereof. However, the overcoat layer OC may not be necessarily limited thereto, and the overcoat layer OC may include a silicon oxide (SiOₓ), a silicon nitride (SiNₓ), a silicon oxynitride (SiOₓN_{y}), an aluminium nitride (AlNₓ), an aluminium oxide (AlOₓ), a zirconium oxide (ZrOₓ), a hafnium oxide (HfOₓ), a titanium oxide (TiOₓ), various types of inorganic materials, or a combination thereof.

Those skilled in the art related to the embodiment will readily appreciate that many modifications may be possible without materially departing from the novel teachings and advantages. The embodiments should be considered in a descriptive sense only and not for purposes of limitation. The scope of the disclosure, not by the detailed description given in the appended claims, and all differences within the equivalent scope will be construed as being included in the disclosure.

## Claims

1. A light emitting element comprising:
a first semiconductor layer;
a second semiconductor layer disposed on the first semiconductor layer;
an active layer disposed between the first semiconductor layer and the second semiconductor layer;
a first insulating film at least partially surrounding the first semiconductor layer, the second semiconductor layer, and the active layer;
a second insulating film surrounding the first insulating film; and
a third insulating film surrounding the second insulating film,
wherein a bond dissociation energy of the second insulating film is less than each of a bond dissociation energy of the first insulating film and a bond dissociation energy of the third insulating film.

2. The light emitting element of claim 1, wherein the bond dissociation energy of the first insulating film is in a range of about 7.0 eV to about 9.0 eV.

3. The light emitting element of claim 1, wherein the bond dissociation energy of the second insulating film is in a range of about 6.0 eV to about 8.5 eV.

4. The light emitting element of claim 1, wherein the bond dissociation energy of the third insulating film is in a range of about 7.0 eV to about 9.0 eV.

5. The light emitting element of claim 1, wherein the first insulating film and the third insulating film include a same material.

6. The light emitting element of claim 1, wherein a thickness of the first insulating film is greater than a thickness of the second insulating film.

7. The light emitting element of claim 6, wherein the thickness of the first insulating film is in a range of about 1 nm to about 5 nm, and the thickness of the second insulating film is in a range of about 1 nm to about 3 nm.

8. The light emitting element of claim 1, wherein a thickness of the third insulating film is greater than a thickness of the second insulating film.

9. The light emitting element of claim 8, wherein
the thickness of the third insulating film is in a range of about 1 nm to about 5 nm, and
the thickness of the second insulating film is in a range of about 1 nm to about 3 nm.

10. The light emitting element of claim 1, further comprising:
a fourth insulating film surrounding the third insulating film.

11. A display device comprising:
a plurality of electrodes spaced apart from each other; and
a plurality of light emitting elements disposed between ones of the plurality of electrodes, wherein
each of the plurality of light emitting elements includes:
a first semiconductor layer;
a second semiconductor layer disposed on the first semiconductor layer;
an active layer disposed between the first semiconductor layer and the second semiconductor layer;
a first insulating film at least partially surrounding the first semiconductor layer, the second semiconductor layer, and the active layer;
a second insulating film surrounding the first insulating film; and
a third insulating film surrounding the second insulating film, and
a bond dissociation energy of the second insulating film is less than each of a bond dissociation energy of the first insulating film and a bond dissociation energy of the third insulating film.

12. The display device of claim 11, wherein the bond dissociation energy of the first insulating film is in a range of about 7.0 eV to about 9.0 eV.

13. The display device of claim 11, wherein the bond dissociation energy of the second insulating film is in a range of about 6.0 eV to about 8.5 eV.

14. The display device of claim 11, wherein the bond dissociation energy of the third insulating film is in a range of about 7.0 eV to about 9.0 eV.

15. The display device of claim 11, wherein the first insulating film and the third insulating film include a same material.

16. The display device of claim 11, wherein a thickness of the first insulating film is greater than a thickness of the second insulating film.

17. The display device of claim 16, wherein
the thickness of the first insulating film is in a range of about 1 nm to about 5 nm, and
the thickness of the second insulating film is in a range of about 1 nm to about 3 nm.

18. The display device of claim 11, wherein a thickness of the third insulating film is greater than a thickness of the second insulating film.

19. The display device of claim 18, wherein
the thickness of the third insulating film is in a range of about 1 nm to about 5 nm, and
the thickness of the second insulating film is in a range of about 1 nm to about 3 nm.

20. The display device of claim 11, further comprising:
a plurality of connection electrodes disposed on the plurality of light emitting elements and being electrically connected to the plurality of light emitting elements.
